# EUROPÄISCHE PATENTSCHRIFT

(11) **EP 0 742 583 B1**
(45) Veröffentlichungstag und Bekanntmachung des Hinweises auf die Patenterteilung: **22.07.1998**
(21) Anmeldenummer: 96107505.8
(22) Anmeldetag: 10.05.1996
(51) Int. Cl.: H01L 21/306

(54) **Verfahren zum Entfernen beschädigter Kristallbereiche von Siliziumscheiben**
Method of removing damaged crystal areas from silicon wafers
Méthode pour enlever régions cristallines endommagées de plaquettes de silicium

(30) Priorität: 11.05.1995 DE 19517371; 26.05.1995 DE 19519455
(43) Veröffentlichungstag der Anmeldung: 13.11.1996
(73) Patentinhaber: Wacker Siltronic Gesellschaft für Halbleitermaterialien Aktiengesellschaft, 84489 Burghausen (DE)
(72) Erfinder: Fabry, Laszlo, Dr., 84489 Burghausen (DE); Steiger, Edeltraud, 84326 Falkenberg (DE); Passer, Bernd, 84489 Burghausen (DE)
(74) Vertreter: Rimböck, Karl-Heinz, Dr.

(56) Entgegenhaltungen:
- DE-A- 2 237 825
- DE-A- 2 526 052
- DE-A- 3 328 639
- US-A- 4 261 791
- JOURNAL OF THE ELECTROCHEMICAL SOCIETY, 1.Januar 1989, Seite 296/297 XP000575047 DYER L D ET AL: "A COMPARISON OF SILICON WAFER ETCHING BY KOH AND ACID SOLUTIONS"

## Beschreibung

Die Erfindung betrifft ein Verfahren zum Entfernen von Kristallbereichen von Siliciumscheiben, die infolge einer mechanischen Bearbeitung der Siliciumscheiben beschädigt sind.

Solche Beschädigungen des Kristallgefüges, der englische Fachausdruck ist "damage", treten zwangsläufig bei der Herstellung von Siliciumscheiben auf. Bereits durch das Abtrennen einzelner Siliciumscheiben von einem gezogenen Einkristall mit Hilfe eines Sägewerkzeuges, beispielsweise einer Draht- oder einer Innenlochsäge, werden die oberflächennahen Kristallbereiche der resultierenden Siliciumscheiben bis in eine Tiefe von ca. 80 µm beschädigt. Dieses durch Sägen entstandene "damage" wird in der Regel durch eine mechanische Oberflächenbehandlung der Siliciumscheiben, beispielsweise durch Läppen oder Schleifen der Scheiben, reduziert. Geläppte oder geschliffene Siliciumscheiben weisen daher nur noch Beschädigungen in der Kristallstruktur auf, die von der Scheibenoberfläche bis in eine Tiefe von ca. 35 µm ins Scheibeninnere reichen. Auch dieses "damage" muß vollständig entfernt werden, wenn zu einem späteren Zeitpunkt vorgesehen ist, auf der Oberfläche der Siliciumscheibe elektronische Schaltkreise zu integrieren.

Eine bekannte Methode, um mechanisch beschädigte Kristallbereiche von Siliciumscheiben zu entfernen, basiert auf anisotropem, chemischem Ätzen der Siliciumscheiben in einem wässerigen, beispielsweise Kalium- und/oder Natriumhydroxid enthaltenden Bad bei Temperaturen von 100 bis 120 °C. Ein besonderer Vorteil dieses einfach durchzuführenden Verfahrens besteht darin, daß es die Scheibenform und die Ebenheit der Scheibenseitenflächen, die durch die mechanische Bearbeitung vorgegeben sind, nicht nachteilig beeinflußt (L.D.Dyer, G.J.Grant, C.M.Tripton, A.E.Stephens, Electrochem. Soc. Symp. Ser., pp.296, June 1989). Andererseits ist das Ätzen unter alkalischen Bedingungen bekannt dafür, daß es Fremdmetalle, die teilweise vom verwendeten Alkalimetallhydroxid stammen, auf den Scheibenoberflächen als Verunreinigungen hinterläßt und daß solche Fremdmetalle wegen der vorherrschenden, relativ hohen Temperaturen von der geätzten Oberfläche ins Scheibeninnere diffundieren. Da Fremdmetallatome die Funktion der elektronischen Bauelemente empfindlich stören, ist bei der Herstellung der Siliciumscheiben besonders darauf zu achten, daß die Verunreinigung durch Fremdmetalle so niedrig wie möglich ist. Fremdmetalle, die während des alkalischen Ätzens ins Scheibeninnere eindiffundieren, stellen deshalb ein besonderes Problem dar, weil sie auch durch eine nachfolgende Reinigung der Scheibenoberflächen nicht mehr entfernt werden können. Eine Verbesserung der Situation durch die Verwendung reinerer Alkalimetallhydroxide scheitert bislang am hohen, technischen und wirtschaftlichen Aufwand, der mit der Bereitstellung solcher Reagentien verbunden ist.

Die Aufgabe der vorliegenden Erfindung bestand deshalb darin, ein Verfahren zum Entfernen beschädigter Kristallbereiche von Siliciumscheiben bereitzustellen, das Probleme hinsichtlich einer Verunreinigung der Siliciumscheiben durch Fremdmetalle vermeidet.

Gelöst wird die Aufgabe durch ein Verfahren, das dadurch gekennzeichnet ist, daß die Siliciumscheiben mit einer Fluorwasserstoff enthaltenden, wässerigen Lösung vorbehandelt werden und danach bei Temperaturen von 55 bis 95 °C in einer mit Ultraschall beaufschlagten, wässerigen Lösung, die Alkalimetallhydroxid enthält, geätzt werden.

Die Vorbehandlung der Siliciumscheiben mit wässeriger Flußsäure-Lösung und das von Ultraschall unterstützte und bei relativ niedrigen Temperaturen vollzogene alkalische Ätzen der Siliciumscheiben hinterläßt eine nur geringe, unvermeidliche Konzentration von Fremdmetallen auf den Scheibenoberflächen. Die Fremdmetalle können anschließend durch bekannte Reinigungsverfahren, beispielsweise durch ein Tauchbad in verdünnter Flußsäure oder in verdünnter Salpetersäure weiter verringert werden. Das Verfahren vermeidet jedoch zuverlässig, daß nicht tolerierbare Mengen an Fremdmetallen in das intakte Kristallgitter eindiffundieren.

Bevorzugt werden die Siliciumscheiben zur Vorbehandlung in eine wässerige, Fluorwasserstoff enthaltende Lösung getaucht. Eintauchzeiten von 60 bis 600 s, bevorzugt 60 bis 180 s sind ausreichend. Die Temperatur der Lösung beträgt vorzugsweise 20 bis 40 °C, besonders bevorzugt 25 °C. Eine andere Ausführungsform des Verfahrens sieht vor, die Flußsäure-Lösung auf die Siliciumscheiben aufzusprühen. Der Anteil an Fluorwasserstoff in der Lösung beträgt vorzugsweise 1 bis 5 Gew.-%, besonders bevorzugt 2 bis 4 Gew.-%. Weiterhin ist es empfehlenswert, aber nicht unbedingt notwendig, daß die Flußsäure-Lösung ein Tensid, vorzugsweise in einer Konzentration von 0,05 bis 2 Gew.-%, besonders bevorzugt 0,5 bis 1 Gew.-% enthält. Bei dem Tensid kann es sich um eine Einzelverbindung oder um eine Mischung verschiedener Einzelverbindungen handeln. Besonders geeignete Tenside sind Nonylphenol-Derivate und Ammoniumlaurylsulfat.

Durch die Vorbehandlung mit verdünnter Flußsäure erhalten die Siliciumscheiben eine hydrophobe Oberfläche, die beim Ätzen unter alkalischen Bedingungen zwei besondere Vorteile bietet. Der Abtrag beschädigter Kristallbereiche erfolgt sehr gleichmäßig und Fremdmetalle, die sich als Verunreinigungen in der später verwendeten Ätzlösung befinden, können nur in einem erheblich eingeschränktem Maße auf den Scheibenoberflächen adsorbieren.

Das sich an die Vorbehandlung anschließende Ätzen der Siliciumscheiben ist unter besonderen Bedingungen durchzuführen. Die Temperaturen im Ätzbad, in das die zu behandelnden Siliciumscheiben getaucht werden, müssen im Bereich von 55 bis 95 °C, bevorzugt 75 bis 80 °C liegen. Darüber hinaus ist das Ätzbad während der Scheibenbehandlung mit Ultraschall zu beaufschlagen, vorzugsweise mit Ultraschall einer Frequenz von 20 bis 80 kHz, besonders bevorzugt 40 kHz, bei einer Leistung von 6 bis 30 W pro Liter wässeriger Ätzlösung, bevorzugt 400 W/15 l. Bei den relativ niedrigen Badtemperaturen ist die Geschwindigkeit, mit der Fremdmetalle ins Innere der Siliciumscheiben diffundieren können, verringert. Die Wirkung des Ultraschalles gleicht eine temperaturbedingt verminderte Geschwindigkeit des Materialabtrages aus. Letztendlich ist die Geschwindigkeit, mit der Silicium von der Oberfläche der Scheiben entfernt wird, höher, als die Geschwindigkeit, mit der Fremdmetalle von der Oberfläche ins Innere der Siliciumscheiben diffundieren.

Prinzipiell kann die chemische Zusammensetzung der wässerigen Ätzlösung einer der bekannten Zusammensetzungen alkalischer Ätzmittel entsprechen. Bevorzugt sind wässerige Lösungen von Kalium- und/oder Natriumhydroxid mit einem Alkalimetallhydroxid-Gehalt von 30 bis 50 Gew.-%, insbesondere 45 bis 50 Gew.-%. Die verwendeten Alkalimetallhydroxide sollten zwar einen möglichst geringen Grad an Verunreinigung durch Fremdmetalle aufweisen. Es ist jedoch nicht notwendig, daß Alkalimetallhydroxide eingesetzt werden, die über das bisher übliche Maß hinaus von Fremdmetallen befreit worden sind.

Die nach dem erfindungsgemäßen Verfahren behandelten Siliciumscheiben sind hinsichtlich der geringen Restkontamination mit Fremdmetallen den säuregeätzten Siliciumscheiben ähnlich. Verfahren, bei denen Säuren zum Ätzen von Siliciumscheiben eingesetzt werden, führen jedoch aufgrund ihrer Ätzkinematik zu ungewünschten Veränderungen der Scheibengeometrie und sind wesentlich aufwendiger in bezug auf Kosten für den Arbeits- und Umweltschutz.

## Patentansprüche

1. Verfahren zum Entfernen von Kristallbereichen von Siliciumscheiben, die infolge einer mechanischen Bearbeitung der Siliciumscheiben beschädigt sind, wobei die Siliciumscheiben mit einer Fluorwasserstoff enthaltenden, wässerigen Lösung vorbehandelt werden und danach bei Temperaturen von 55 bis 95 °C in einer mit Ultraschall beaufschlagten, wässerigen Lösung, die Alkalimetallhydroxid enthält, geätzt werden.

2. Verfahren nach Anspruch 1, dadurch gekennzeichnet, daß die Siliciumscheiben zur Vorbehandlung in eine wässerige Lösung getaucht werden, die 1 bis 5 Gew.-% Fluorwasserstoff und gegebenenfalls 0,05 bis 2 Gew.-% Tensid enthält.

3. Verfahren nach Anspruch 1, dadurch gekennzeichnet, daß auf die Oberflächen der Siliciumscheiben zur Vorbehandlung eine wässerige Lösung gesprüht wird, die 1 bis 5 Gew.-% Fluorwasserstoff und gegebenenfalls 0,05 bis 2 Gew.-% Tensid enthält.

4. Verfahren nach einem der Ansprüche 1 bis 3, dadurch gekennzeichnet, daß die Siliciumscheiben in einer wässerigen Lösung von Kalium- und/oder Natriumhydroxid geätzt werden.

5. Verfahren nach einem der Ansprüche 1 bis 4, dadurch gekennzeichnet, daß die Alkalimetallhydroxid enthaltende Lösung mit Ultraschall einer Frequenz von 20 bis 80 kHz beaufschlagt wird.

## Claims

1. Method of removing crystal regions from silicon wafers which are damaged as a consequence of mechanical machining of the silicon wafers, in which the silicon wafers are pretreated with an aqueous solution containing hydrogen fluoride and are then etched in an aqueous solution exposed to ultrasound and containing alkalimetal hydroxide at temperatures from 55 to 95°C.

2. Method according to Claim 1, characterized in that, for the purpose of pretreatment, the silicon wafers are immersed in an aqueous solution containing 1 to 5% by weight of hydrogen fluoride and, optionally, 0.05 to 2% by weight of surfactant.

3. Method according to Claim 1, characterized in that, for the purpose of pretreatment, there is sprayed onto the surfaces of the silicon wafers an aqueous solution containing 1 to 5% by weight of hydrogen fluoride and, optionally, 0.05 to 2% by weight of surfactant.

4. Method according to one of Claims 1 to 3, characterized in that the silicon wafers are etched in an aqueous solution of potassium hydroxide and/or sodium hydroxide.

5. Method according to one of Claims 1 to 4, characterized in that the solution containing alkalimetal hydroxide is exposed to ultrasound having a frequency of 20 to 80 kHz.

## Revendications

1. Procédé pour l'élimination de zones cristallines de tranches de silicium endommagées à la suite d'un traitement mécanique des tranches de silicium, dans lequel les tranches de silicium sont prétraitées au moyen d'une solution aqueuse contenant du fluorure d'hydrogène, et sont ensuite décapées, à une température de 55 à 95°C, au moyen d'une solution aqueuse contenant de l'hydroxyde de métal alcalin, agitée par des ultrasons.

2. Procédé selon la revendication 1, caractérisé en ce que les tranches de silicium sont plongées, pour le prétraitement, dans une solution aqueuse contenant de 1 à 5 % en poids de fluorure d'hydrogène, et éventuellement de 0,05 à 2 % en poids d'un agent tensio-actif.

3. Procédé selon la revendication 1, caractérisé en ce qu'on pulvérise, sur la surface des tranches de silicium, pour le prétraitement, une solution aqueuse contenant de 1 à 5 % en poids de fluorure d'hydrogène, et éventuellement de 0,05 à 2 % en poids d'un agent tensio-actif.

4. Procédé selon l'une quelconque des revendications 1 à 3, caractérisé en ce que les tranches de silicium sont décapées dans une solution aqueuse d'hydroxyde de potassium et/ou de sodium.

5. Procédé selon l'une quelconque des revendications 1 à 4, caractérisé en ce que la solution contenant de l'hydroxyde de métal alcalin est agitée au moyen d'ultrasons d'une fréquence de 20 à 80 kHz.
